# EUROPEAN PATENT SPECIFICATION

(11) **EP 2 602 537 B1**
(45) Date of publication and mention of the grant of the patent: **28.02.2018**
(21) Application number: 11814468.2
(22) Date of filing: 22.07.2011
(51) Int. Cl.: F21S 2/00, F21S 8/12, G03B 21/14, G03B 21/20, C09K 11/64, G02B 5/02, G02B 27/10, G02B 27/14, H01L 33/50, G02B 19/00

(54) **LIGHT SOURCE DEVICE**
LICHTQUELLENVORRICHTUNG
DISPOSITIF DE SOURCE DE LUMIÈRE

(30) Priority: 04.08.2010 JP 2010175158
(43) Date of publication of application: 12.06.2013
(73) Proprietor: Ushio Denki Kabushiki Kaisha, Tokyo 100-8150 (JP)
(72) Inventor: KABUKI, Kiyoyuki, Himeji-shi, Hyogo 671-0224 (JP); HORIKAWA, Yoshihiro, Himeji-shi, Hyogo 671-0224 (JP); YOSHIDA, Kazuhiro, Himeji-shi, Hyogo 671-0224 (JP)
(74) Representative: Price, Christopher
(86) International application number: PCT/JP2011/066671
(87) International publication number: WO 2012/017838

(56) References cited:
- WO-A2-2008/036958
- WO-A2-2009/092041
- CN-A- 101 539 270
- JP-A- 2005 347 263
- JP-A- 2007 200 782
- JP-A- 2008 116 784
- US-A1- 2010 012 959

## Description

### Technical Field

The present invention relates to a light source device which can be suitably used as a light source of a projector.

### Background Art

Conventionally, a short arc type high-voltage discharge lamp has been used as a light source of a projector. Thus, recently, there has been proposed a projector using a solid light-emitting device, such as a light-emitting diode, a laser diode or the like, as a light source (refer to Patent document 1). Such a projector using a solid light-emitting device is advantageous compared to a projector using a high-voltage discharge lamp in that a high-voltage power source is not needed, the life cycle of a solid light-emitting device as a light source is long, and impact resistance is high.

However, this projector is problematic in that it is difficult to realize low cost because three kinds of solid light-emitting devices emitting red, green and blue light are needed, and in that it is difficult to obtain a sufficient amount of luminescence because a cheap solid light-emitting device emitting a large amount of green light does not exist.

In order to solve the above problem, there is proposed a light source device including: an excited light source for emitting excited light; and a wavelength conversion member including a wavelength conversion layer made of a fluorescent material converting excited light into visible light and formed on a glass substrate (Refer to Patent document 2).

According to such a light source device, when the kind of the fluorescent material constituting the wavelength conversion layer is selected, excited light emitted from the excited light source can be converted into visible light of red, green and blue colors, so it is not required to use three kinds of solid light-emitting devices, and a large amount of green light can be obtained.

However, this light source device is problematic for the following reasons.

The wavelength conversion layer in the wavelength conversion member is formed by any one of the following methods: (1) applying a mixed solution containing a binder and a fluorescent material onto the surface of a glass substrate, drying the mixed solution and then sintering the dried mixed solution at a temperature of 650 ∼ 700 °C; (2) applying a sol containing a metal alkoxide and a fluorescent material onto the surface of a glass substrate, hydrolyzing and polycondensing the sol to form a gel film and then calcining the gel film; (3) depositing a fluorescent material onto the surface of a glass substrate; and (4) fabricating a compact for a wavelength conversion layer containing a transparent resin (silicon resin) and a fluorescent and then attaching the compact to a glass substrate.

However, when a wavelength conversion layer is formed by any one of the above methods (1) to (3), the thickness of the obtained wavelength conversion layer is small, so a part of the excited light emitted from an excited light source penetrates the wavelength conversion layer, with the result that it is difficult to emit light having a desired wavelength at a high level of efficiency.

Meanwhile, when a wavelength conversion layer is formed by the above method (4), it is possible to obtain a wavelength conversion layer having a large thickness, but the transparent resin constituting the wavelength conversion layer is easily decomposed or deteriorated by excited light or by heat caused by excited light, so the obtained wavelength conversion layer is not suitable as a wavelength conversion layer used for a light source device of a projector requiring a large amount of luminescence.

### [Prior art documents]

### [Patent documents]

Japanese Patent Application Publication No. 2002 - 268140
Japanese Patent Application Publication No. 2004 - 341105

CN 101 539 27 A discloses a method of converting the wavelength of light in which light from a light source is guided into a wavelength conversion layer comprising a wavelength conversion material. A film having a lower refractive index than the wavelength conversion layer is mounted on at least one side of the wavelength conversion layer. The refractive index difference causes reflection of excited light emerging from the wavelength conversion layer at large angles by total internal reflection. An angle selection light-filtering film is mounted on one side of the wavelength conversion layer which enables excited light emerging at smaller angles than a pre-set emergence angle to leave the wavelength conversion layer. On the other side of the wavelength conversion layer is mounted a reflecting film.

WO 2009/092041 discloses illumination systems, utilising wavelength conversion material, with an omnidirectional reflector. Light enters an interior cavity of a hollow light guide where part of it strikes a wavelength conversion layer. Part of the light striking the wavelength conversion layer is absorbed and converted into light with a new wavelength and the remainder of the light is diffused. The source light and the converted light are collimated by the light guide and impinge on an optical element at a reduced angle with respect to that of the diffused source light and the converted light.

WO 2008/036958 discloses a light source that includes an angle-selective filter and a light emitting diode (LED) having a high reflective layer. The angle-selective filter is located on a top surface of the LED so as to pass light at specific angles and to reflect light at other angles.

US 2010/012959 discloses an optoelectronic component in which a semiconductor layer sequence includes an active region which radiates electromagnetic radiation with a first spectrum. A wavelength conversion layer in the beam path of the electromagnetic radiation with the first spectrum converts a sub-spectrum of the first spectrum into electromagnetic radiation with a second spectrum. A filter layer located above the wavelength conversion layer reflects part of the radiation spectrum.

### Disclosure

### Technical Problem

Accordingly, the present invention has been devised based on the above circumstances, and an object of the present invention is to provide a light source device converting excited light into long-wavelength light having longer wavelength than the excited light, which can emit light having a desired wavelength at a high level of efficiency.

### Technical Solution

An aspect of the present invention provides a light source device as defined in independent claim 1, including: an excited light source emitting excited light; a wavelength conversion member including a light transmission plate and a wavelength conversion layer formed on the light transmission plate and receiving the excited light from the excited light source and emitting long-wavelength light having a longer wavelength than the excited light, the excited light emitted from the excited light source being incident upon one side of the wavelength conversion layer; a light reflection member provided at said one side of the wavelength conversion member and including an excited light transmission window transmitting the excited light; and a filter member provided at the other side of the wavelength conversion member and reflecting the excited light and transmitting the long-wavelength light.

Another aspect of the present invention provides a light source as defined in independent claim 2, including: an excited light source emitting excited light; a wavelength conversion member including a light transmission plate and a wavelength conversion layer formed on the light transmission plate and receiving the excited light from the excited light source and emitting long-wavelength light having a longer wavelength than the excited light, the excited light emitted from the excited light source being incident upon one side of the wavelength conversion layer; a filter member provided at said one side of the wavelength conversion member, including an excited light transmission window transmitting the excited light and reflecting the excited light and transmitting the long-wavelength light; and a light reflection member provided at the other side of the wavelength conversion member.

In the light source device, the long-wavelength light emitted from the wavelength conversion layer may be green light.

Further, the excited light emitted from the excited light source may be incident upon one side of the wavelength conversion member in a state in which an optical axis of the excited light is inclined to a surface normal of one side of the wavelength conversion member, and the optical axis of the excited light incident upon one side of the wavelength conversion member may be inclined at an angle of 3 ∼ 10° to the surface normal of one side of the wavelength conversion member.

Further, the wavelength conversion layer may be formed by a sol-gel process or a deposition process.

### Advantageous Effects

According to the light source device of the present invention, even when a part of excited light emitted from an excited light source penetrates a wavelength conversion layer, the excited light is reflected by a filter member or a light reflection member, so the excited light is incident upon the wavelength conversion layer again, with the result that the excited light emitted from the excited light source can be efficiently converted into long-wavelength light, thereby emitting light having a desired wavelength at a high level of efficiency.

### Description of Drawings

FIG. 1 is a schematic drawing showing a light source device according to a first embodiment not part of the present invention.
FIG. 2 is a sectional view showing the structure of a light reflection member.
FIG. 3 is a schematic drawing showing the state of excited light and long-wavelength light in the light source device according to the first embodiment of the present invention.
FIG. 4 is a schematic drawing showing a light source device according to a second embodiment not part of the present invention.
FIG. 5 is a schematic drawing showing the state of excited light and long-wavelength light in the light source device according to the second embodiment of the present invention.
FIG. 6 is a schematic drawing showing a light source device according to a third embodiment of the present invention.
FIG. 7 is a schematic drawing showing a modified example of the light source device according to the first embodiment of the present invention.
FIG. 8 is a schematic drawing showing a modified example of the light source device according to the second embodiment of the present invention.
FIG. 9 is a schematic drawing showing a light source device according to another not part of the present invention.
FIG. 10 is a schematic drawing showing a light source device according to still another embodiment not part of the present invention.

### Best Mode

Hereinafter, preferred embodiments of the light source device of the present invention will be described.

### [First embodiment]

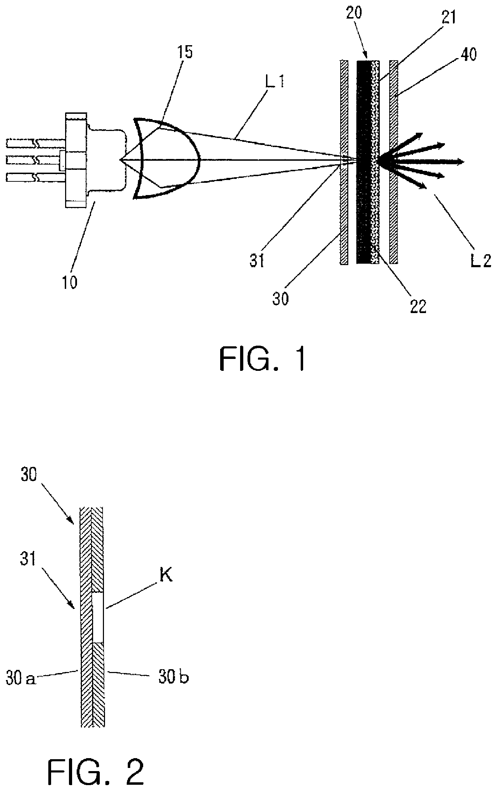

FIG. 1 is a schematic drawing showing a light source device according to a first embodiment not part of the present invention. This light source device includes an excited light source 10, and a plate-shaped wavelength conversion member 20, to one side (left side in FIG. 1) of which excited light L1 emitted from the excited light source 10 is applied, and which is provided in front of the excited light source 10. Here, the excited light source 10 is disposed such that the optical axis of the excited light L1 emitted from the excited light source 10 to the wavelength conversion member 20 is perpendicular to one side of the wavelength conversion member 20.

The wavelength conversion member 20 includes: a light transmission plate 22; and a wavelength conversion layer 21 formed on the light transmission plate 22 and containing a fluorescent material for receiving excited light L1 from the excited light source 10 and emitting long-wavelength light L2having a longer wavelength than the excited light L1. The surface of the wavelength conversion layer 21 may be provided with a glass-made protection layer (not shown). Further, as shown in FIG. 1, the wavelength conversion member 20 may be configured such that the wavelength conversion layer 21 is opposite to the excited light source 10, and thus the excited light L1 emitted from the excited light source 10 is incident upon one surface of the light transmission plate 22, the one surface thereof that is not provided with the wavelength conversion layer 21.

A plate-shaped or film-shaped light reflection member 30 having an excited light transmission window 31 through which the excited light L1 emitted from the excited light source 10 passes is provided at one side of the wavelength conversion member 20. Meanwhile, a plate-shaped or film-shaped filter member 40 is provided at the other side of the wavelength conversion member 20.

Further, as shown in FIG. 1, a collimator lens 15 for condensing the excited light L1 emitted from the excited light source 10 is provided between the excited light source 10 and the light reflection member 30.

A solid light-emitting device, such as a light-emitting diode, a laser diode or the like, may be used as the excited light source 10. For example, a blue laser diode may be suitably used as the excited light source 10.

The long-wavelength light L2 emitted from the wavelength conversion layer 21 of the wavelength conversion member 20 may be any one of red light, green light and blue light, and preferably green light.

The fluorescent material constituting the wavelength conversion layer 21 may be suitably selected depending on the wavelength of the excited light L1 emitted from the excited light source 10 and the wavelength of the light emitted from the wavelength conversion layer 21. For example, when the wavelength conversion layer 21 receives the excited light L1 from the excited light source 10 made of blue light-emitting diodes and emits green light, it is preferred that a β-sialon green fluorescent material be used because it has high chemical and thermal stability and because its fluorescent characteristics slightly change when the humidity or temperature in the environment changes, and thus it does not easily deteriorate.

Further, it is preferred that the thickness of the wavelength conversion layer 21 be 50 ∼1 00 µm. In the case where the wavelength conversion layer 21 is excessively thin, when the excited light source 10 passes through the wavelength conversion layer 21, the probability of the excited light L1 being absorbed and the wavelength thereofbeing converted becomes low, so the excited light L1 is repetitively reciprocally reflected between the light reflection member 30 and the filter member 40, and thus the emission region from the wavelength conversion layer 21 is enlarged, with the result that luminance becomes low as a light source, and thus it is difficult to obtain a sufficient amount of light as projector. Meanwhile, in the case where the wavelength conversion layer 21 is excessively thick, when the wavelength conversion member 20 receives a thermal history attributable to the excited light L1, stress is caused by the difference in thermal expansion coefficient between a material constituting the light transmission plate 22 and a material constituting the wavelength conversion layer 21, so the wavelength conversion layer 21 cracks, and thus the wavelength conversion layer 21 absorbs light, thereby deteriorating luminance characteristics. Further, as shown in FIG. 1, in the case where the wavelength conversion member 20 is configured such that light penetrates it, the amount of light penetrating the wavelength conversion member 20 decreases, so the long-wavelength light L2 emitted from the wavelength conversion layer 21 is repetitively reciprocally reflected between the light reflection member 30 and the wavelength conversion member 20, with the result that the amount of the long-wavelength light L2 absorbed in the light reflection member 30 or the wavelength conversion member 20 increases, thereby deteriorating luminance as a light source.

Generally, a method of forming the wavelength conversion layer 21 includes the steps of: applying a mixed solution containing a binder and a fluorescent material onto the surface of a light transmission plate 22; drying the mixed solution; and sintering the mixed solution at 650 ∼ 700 °C. However, in this method, fluorescent material particles are exposed from the light transmission plate 22, thus forming an uneven scattering plane. Further, the wavelength conversion layer 21 may be formed by dispersing the mixed solution in a silicone resin or the like, but, even in this method, it is difficult to obtain an optically flat surface. For this reason, it is preferred that the wavelength conversion layer 21 be formed by a sol-gel process including the steps of applying a sol containing a metal alkoxide and a fluorescent material onto the surface of a light transmission plate 22; performing hydrolysis and polycondensation reactions to form a gel film; and calcining the gel film, or be formed by depositing a fluorescent material onto the surface of a light transmission plate 22. The wavelength conversion layer 21 formed in this way has an optically flat surface, and can be directly provided on the surface thereof with a filter member 40. By this means, it is possible to obtain a wavelength conversion layer 21 having uniform thickness and to form another optical layer on the wavelength conversion layer 21.

As the light transmission plate 22, a light transmission plate, which is made of quartz, glass or the like, and through which both the excited light L1 emitted from the excited light source 10 and the long-wavelength light L2 emitted from the wavelength conversion layer 21 are transmitted, can be used.

Further, the thickness of the light transmission plate 22 may be 0.6 ∼ 1. 5 mm, although it is changed depending on the size thereof Basically, in order to control the diffusion of light caused by the reciprocal reflection of excited light L1 and long-wavelength light L2, it is preferred that the thickness of the light transmission plate 22 be small.

The light reflection member 30 is not particularly limited as long as it can reflect both the excited light L1 emitted from the excited light source 10 and the long-wavelength light L2 emitted from the wavelength conversion layer 21. The light reflection member 30 may be made of a metal having high light reflectivity such as silver, aluminum or the like. However, in the case where a blue laser diode is used as the excited light source 10 and a fluorescent material emitting green light is used as the wavelength conversion layer 21, as shown in FIG. 2, the light reflection member 30 may be a laminate including a dielectric multilayer 30a made of TiO₂ and SiO₂ and reflecting blue light having a wavelength band of 420 ∼ 470 nm and a dielectric multilayer 30b made of TiO₂ and SiO₂ and reflecting green light having a wavelength band of 490 ∼ 560 nm.

Such a light reflection member 30 may be formed by deposition.

Further, the light reflection member 30 may be integrated with the wavelength conversion member 20 or may be separately provided from the wavelength conversion member 20.

The excited light transmission window 31 of the light reflection member 30 is not particularly limited as long as it can transmit excited light L1. The excited light transmission window 31 may be formed by an opening or may be formed of a material transmitting excited light L1. However, it is preferred that the excited light transmission window 31 reflect the long-wavelength light L2 emitted from the wavelength conversion layer 21. Specifically, for example, in the case where the light reflection member 30 is a laminate including the dielectric multilayer 30a reflecting blue light and the dielectric multilayer 30b reflecting green light, as shown in FIG. 2, the dielectric multilayer 30a reflecting blue light may be provided with an opening K for the excited light transmission window 31, and the dielectric multilayer 30b reflecting green light may transmit blue light. According to such a configuration, the long-wavelength light L2 emitted from the wavelength conversion layer 21 is reflected by the dielectric multilayer 30b of the excited light transmission window 31, so it is possible to prevent the long-wavelength light L2 from leaking from the excited light transmission window 31, thereby obtaining much higher luminance efficiency with respect to the long-wavelength light L2 emitted from the wavelength conversion layer 21.

The filter member 40 serves to reflect the excited light L1 emitted from the excited light source 10 and transmit the long-wavelength light L2 emitted from the wavelength conversion layer 21.

This filter member 40 may be formed of a dielectric multilayer made of TiO₂ and SiO₂.

Such a filter member 40 may be formed by deposition.

Further, this filter member 40 may be integrated with the wavelength conversion member 20 or may be separately provided from the wavelength conversion member 20.

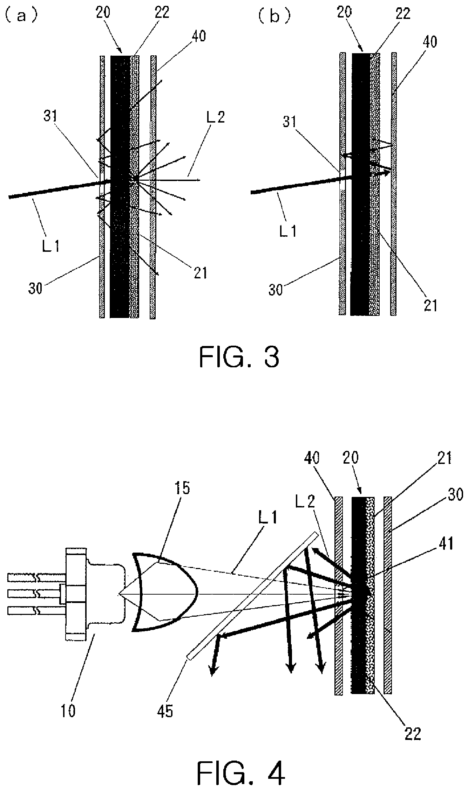

In the light source device, the excited light L1 emitted from the excited light source 10 is condensed by a collimator lens 15, and is then incident upon one side of the wavelength conversion member 20 (for example, one side of the light transmission plate 22) through the excited light transmission window 31 of the light reflection member 30 as shown in FIG. 3(a). When the excited light L1 is incident upon the wavelength conversion layer 21 of the wavelength conversion member 120, long-wavelength light L2 having longer wavelength than the excited light L1 is emitted from the wavelength conversion layer 21. Among the long-wavelength light L2, the light moving toward the filter member 40 is emitted to the outside through the filter member 40, and the light moving toward the light reflection member 30 is reflected by the light reflection member 30 and then emitted to the outside through the wavelength conversion member 20 and the filter member 40.

Meanwhile, as shown in FIG. 3 (b), the excited light L1 having passed through the wavelength conversion layer 21 is reflected by the filter member 40 and then incident upon the wavelength conversion layer 21, and thus long-wavelength light is emitted from the wavelength conversion layer 21. Further, the excited light L1 having passed through the wavelength conversion layer 21 is reflected by the light reflection member 30 and then incident upon the wavelength conversion layer 21, and thus long-wavelength light is emitted from the wavelength conversion layer 21.

According to the light source device, even when a part of the excited light L1 emitted from the excited light source 10 passes through the wavelength conversion layer 21, the excited light L1 is reflected by the filter member 40 or the light reflection member 30, so the reflected excited light is incident upon the wavelength conversion layer 21 again, with the result that the excited light L1 can be converted into long-wavelength light L2 at a high level of efficiency, thereby emitting light having a desired wavelength at a high level of efficiency.

### [Second embodiment]

FIG. 4 is a schematic drawing showing a light source device according to a second embodiment not part of the present invention. This light source device includes an excited light source 10, and a plate-shaped wavelength conversion member 20, to one side (left side in FIG. 4) of which excited light L1 emitted from the excited light source 10 is applied, and which is provided in front of the excited light source 10. The excited light source 10 is disposed such that the optical axis of the excited light L1 emitted from the excited light source 10 to the wavelength conversion member 20 is perpendicular to one side of the wavelength conversion member 20.

This wavelength conversion member 20 includes: a light transmission plate 22; and a wavelength conversion layer 21 formed on the light transmission plate 22 and containing a fluorescent material for receiving excited light L1 from the excited light source 10 and emitting long-wavelength light L2 having longer wavelength than the excited light L1. The surface of the wavelength conversion layer 21 may be provided with a glass-made protection layer (not shown). Further, as shown in FIG. 4, the wavelength conversion member 20 may be configured such that the wavelength conversion layer 21 is opposite to the excited light source 10, and thus the excited light L1 emitted from the excited light source 10 is incident upon one surface of the light transmission plate 22, the one surface thereof being not provided with the wavelength conversion layer 21.

A plate-shaped or film-shaped filter member 40 having an excited light transmission window 41 through which the excited light L1 emitted from the excited light source 10 passes, reflecting the excited light L1 emitted from the excited light source 10 and transmitting the long-wavelength light L2 emitted from the wavelength conversion layer 21 is provided at one side of the wavelength conversion member 20. Meanwhile, a plate-shaped or film-shaped light reflection member 30 is provided at the other side of the wavelength conversion member 20.

Further, as shown in FIG. 4, a collimator lens 15 for condensing the excited light L1 emitted from the excited light source 10 is provided between the excited light source 10 and the filter member 40. Further, a plate-shaped wavelength selection mirror 45 transmitting the excited light L1 emitted from the excited light source 10 and reflecting the long-wavelength light L2 emitted from the wavelength conversion layer 21 is disposed between the collimator lens 15 and the filter member 40 such that it is inclined, for example, at an angle of 45 degrees to the wavelength conversion member 20.

The excited light source 10 and wavelength conversion member 20 of the light source device according the second embodiment of the present invention may be the same as those of the light source device according to the first embodiment of the present invention. Further, the materials constituting the light reflection member 30 and filter member 40 of the light source device according the second embodiment of the present invention may be the same as those of the light source device according to the first embodiment of the present invention.

The excited light transmission window 41 of the filter member 40 is not particularly limited as long as it can transmit excited light L1. However, it is preferred that the excited light transmission window 41 transmit the long-wavelength light L2 emitted from the wavelength conversion layer 21. Specifically, the excited light transmission window 41 may be formed by an opening or may be formed of a material transmitting both excited light L1 and long-wavelength light L2.

The wavelength selection mirror 45 may be formed of a dielectric multilayer made of TiO₂ and SiO₂.

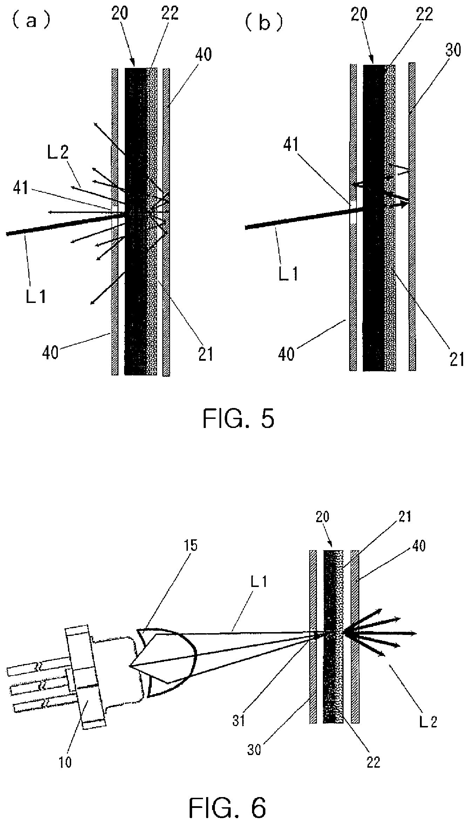

In the light source device, the excited light L1 emitted from the excited light source 10 is condensed by a collimator lens 15, is passed through the wavelength selection mirror 45, and is then incident upon one side of the wavelength conversion member 20 (for example, one side of the light transmission plate 22) through the excited light transmission window 41 of the filter member 40 as shown in FIG. 5(a).

In this case, when the excited light L1 is incident upon the wavelength conversion layer 21 of the wavelength conversion member 20, long-wavelength light L2 having longer wavelength than the excited light L1 is emitted from the wavelength conversion layer 21. Among the long-wavelength light L2, the light moving toward the filter member 40 is passed through the filter member 40 and is reflected by the wavelength selection mirror 45 to be emitted to the outside, and the light moving toward the light reflection member 30 is reflected by the light reflection member 30, passed through the wavelength conversion member 20 and the filter member 40, and then reflected by the wavelength selection mirror 45 to be emitted to the outside.

Meanwhile, as shown in FIG. 5 (b), the excited light L1 having passed through the wavelength conversion layer 21 is reflected by the light reflection member 30 and then incident upon the wavelength conversion layer 21, and thus long-wavelength light is emitted from the wavelength conversion layer 21. Further, the excited light L1 having passed through the wavelength conversion layer 21 is reflected by the filter member 40 and then incident upon the wavelength conversion layer 21, and thus long-wavelength light is emitted from the wavelength conversion layer 21.

According to the light source device, even when a part of the excited light L1 emitted from the excited light source 10 passes through the wavelength conversion layer 21, the excited light L1 is reflected by the light reflection member 30 or the filter member 40, so the reflected excited light is incident upon the wavelength conversion layer 21 again, with the result that the excited light L1 can be converted into long-wavelength light L2 at a high level of efficiency, thereby emitting light having a desired wavelength at a high level of efficiency.

### [Third embodiment]

FIG. 6 is a schematic drawing showing a light source device according to a third embodiment of the present invention. This light source device is configured in the same manner as the light source device according to the first embodiment of the present invention, except that the excited light source 10 is disposed such that the excited light L1 emitted from the excited light source 10 is incident upon one side of the wavelength conversion member 20 in a direction in which the optical axis of the excited light L1 is inclined to the surface normal of one side of the wavelength conversion member 20.

In the light source device configured in this way, it is preferred that the optical axis of the excited light L1 incident upon one side of the wavelength conversion member 20 be inclined at an angle of 3 ∼ 10° to the surface normal of one side of the wavelength conversion member 20.

Such a light source device can exhibit the same effects as the light source device according to the first embodiment of the present invention, and can also exhibit the following effects.

That is, when the excited light L1 having passed through the excited light transmission window 31 of the light reflection member 30 is incident upon one side of the wavelength conversion member 20 in a direction in which the optical axis of the excited light L1 is inclined to the surface normal of one side of the wavelength conversion member 20, the reflection angle of the excited light L1 having passed through the wavelength conversion layer 21 is greater than 0° when it was reflected by the filter member 40, so it is possible to prevent or inhibit the excited light L1 reflected by the filter member 40 from leaking from the excited light transmission window 31 of the light reflection member 30 when the excited light L1 passed through the wavelength conversion layer 21 again, thereby obtaining a much higher luminance efficiency.

### [Other embodiments]

The light source devices according to the first to third embodiments were above-described. However, the light source device of the present invention is not limited to the above-mentioned embodiments, and can be variously modified.

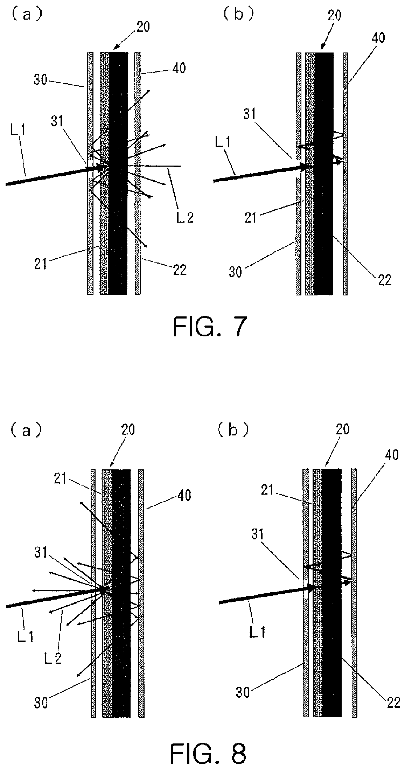

For example, in the first and second embodiments, as shown in FIGS. 7 and 8, the wavelength conversion member 20 may be disposed such that the wavelength conversion layer 21 faces the excited light source 10, so the excited light L1 emitted from the excited light source 10 may be incident upon the surface of the wavelength conversion layer 21.

Further, in the second embodiment, the excited light source 10 may be disposed such that the excited light L1 emitted from the excited light source 10 is incident upon one side of the wavelength conversion member 20 in a direction in which the optical axis of the excited light L1 is inclined to the surface normal of one side of the wavelength conversion member 20.

The light source device configured in this way can exhibit the same effect as the light source device according to the third embodiment of the present invention. That is, the reflection angle of the excited light L1 having passed through the wavelength conversion layer 21 is greater than 0° when it was reflected by the light reflection member 30, so it is possible to prevent or inhibit the excited light L1 reflected by the light reflection member 30 from leaking from the excited light transmission window 41 of the filter member 40 when the excited light L1 passed through the wavelength conversion layer 21 again, thereby obtaining a much higher luminance efficiency.

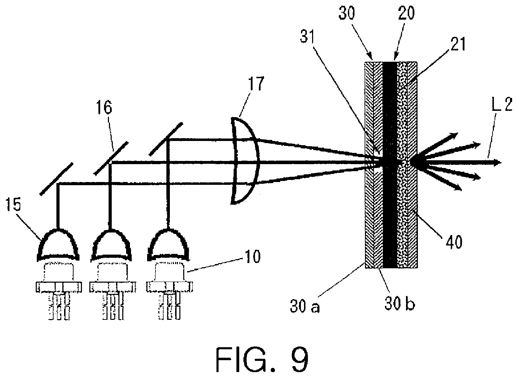

Further, as shown in FIG. 9, the light source device not part of the present invention may be provided with a plurality of excited light sources 10, may be configured such that the plurality of excited light sources 10 are disposed so that the optical axis of excited light L1 emitted from each of the excited light sources 10 intersects the surface normal of one side of the wavelength conversion member 20, for example, at an angle of 90°, and may be provided with light reflection plates 16 for reflecting the excited light L1 emitted from each of the excited light sources 10 toward the wavelength conversion member 20 and a condensing lens 17 for condensing the excited light L1 reflected by the light reflection plates 16 on the optical path of the excited light L1 from each of the excited light sources to the wavelength conversion layer 20.

### Mode for Invention

### <Examples>

Hereinafter, the present invention will be described in more detail with reference to the following Examples. However, the present invention is not limited thereto.

### <Example 1>

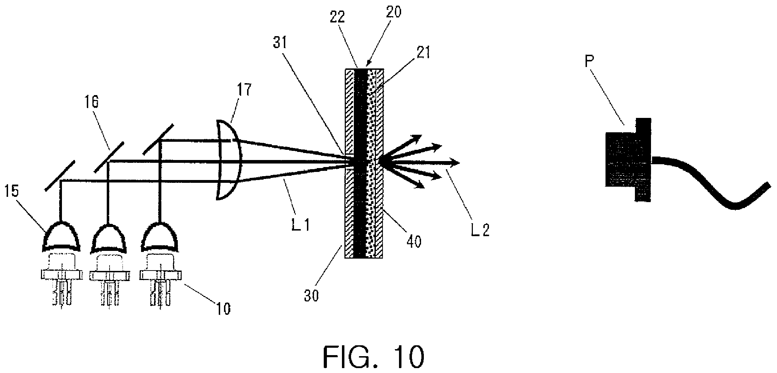

A light source device was fabricated under the following conditions as shown in FIG. 10.

### Excited light sources (10):

12 1W blue laser diodes (peak wavelength: 445 nm) were disposed as excited light sources (10).

### Wavelength conversion member (20):

A wavelength conversion member (20) was fabricated using a sol containing dispersed β-sialon particles having a median diameter (D₅₀) of 18 µm as a fluorescent material by a sol-gel process including the steps of: forming a wavelength conversion layer (21) having a thickness of 55 µm on a quartz glass-made light transmission plate (22) having a thickness of 0.8 mm; and grinding the surface of the wavelength conversion layer (21).

### Light reflection member (30):

A light reflection member (30) having a thickness of 1 µm and provided with an excited light transmission window (31) including an opening having a diameter of 1 mm was formed by depositing silver on one side of the wavelength conversion member (20) not provided with a wavelength conversion layer (21).

### Filter member (40):

A filter member (40) including several tens of dielectric multilayers made of TiO₂ and SiO₂ and having a thickness of 2 µm was formed on the surface of the wavelength conversion layer (21) of the wavelength conversion member (20). The wavelength band of the light reflected by the filter member (40) is 420 ∼ 480 nm.

### <Example 2>

A light source device was fabricated in the same manner as in Example 1, except that the thickness of a wavelength conversion layer (21) was 95 µm.

### <Comparative Example 1>

A light source device was fabricated in the same manner as in Example 1, except that a filter member (40) was not formed.

### <Comparative Example 2>

A light source device was fabricated in the same manner as in Example 2, except that a filter member (40) was not formed.

### [Measurement of illuminance of light source device]

As shown in FIG. 10, an illuminometer (P) was disposed in front of each of the light source devices of Examples 1 and 2 and Comparative Examples 1 and 2, and then the illuminance of the light emitted from each of the light source devices was measured. Here, the distance between the wavelength conversion member (20) and the illuminometer (P) was 30 cm. The results thereof, each of which is relative illuminance when the illuminance of the light emitted from the light source device of Comparative Example 1 is set 100, are given in Table 1 below.

**[Table 1]**

| | Thickness of wavelength conversion layer (µm) | Existence and nonexistence of filter member | Relative illumination |
|---|---|---|---|
| Ex. 1 | 55 | existence | 220 |
| Ex. 2 | 95 | existence | 210 |
| Com. Ex. 1 | 55 | nonexistence | 100 |
| Com. Ex. 2 | 95 | nonexistence | 180 |

From the results of Table 1, it can be ascertained that the light source devices of Examples 1 and 2 can convert excited light into long-wavelength light at a high level of efficiency compared to the light source devices of Comparative Examples 1 and 2, thus more efficiently emitting the light having a desired wavelength.

**[Reference Numerals]**

| | |
|---|---|
| 10 excited light source | 15: collimator lens |
| 16: light reflection plate | 17: condenser lens |
| 20: wavelength conversion member | |
| 21: wavelength conversion layer | |
| 22: light transmission plate | |
| 30: light reflection member | |
| 30a, 30b: dielectric multilayer | |
| 31: excited light transmission window | |
| 40: filter member | |
| 41: excited light transmission window | |
| 45: wavelength selection mirror | |
| K: opening | |
| L1: excited light | |
| L2: long-wavelength light | |
| P: illuminometer | |

## Claims

1. A light source device, comprising:
an excited light source (10) emitting excited light (L1);
a plate-shaped wavelength conversion member (20) including a light transmission plate (22) and a wavelength conversion layer (21) formed on the light transmission plate (22) and receiving the excited light (L1) from the excited light source (10) and emitting long-wavelength light (L2) having a longer wavelength than the excited light (L1), the excited light (L1) emitted from the excited light source (10) being incident upon one side of the wavelength conversion member (20) ; and
a plate-shaped filter member (40) provided at the other side of the wavelength conversion member (20) and reflecting the excited light (L1) and transmitting the long-wavelength light (L2),
**characterised by**:
a plate-shaped light reflection member (30) provided at said one side of the wavelength conversion member (20), the light reflection member (30) reflecting excited light (L1) and long-wavelength light (L2) and including an excited light transmission window (31) transmitting the excited light (L1),
wherein the excited light (L1) emitted from the excited light source (10) is incident upon one side of the wavelength conversion member (20) in a state in which an optical axis of the excited light (L1) is inclined to a surface normal of one side of the wavelength conversion member (20).

2. A light source device, comprising:
an excited light source (10) emitting excited light (L1);
a plate-shaped wavelength conversion member (20) including a light transmission plate (22) and a wavelength conversion layer (21) formed on the light transmission plate (22) and receiving the excited light (L1) from the excited light source (10) and emitting long-wavelength light (L2) having a longer wavelength than the excited light (L1), the excited light (L1) emitted from the excited light source (10) being incident upon one side of the wavelength conversion member (20) ; and
a plate-shaped light reflection member (30) provided at the other side of the wavelength conversion member (20),
**characterised by**:
a plate-shaped filter member (40) reflecting the excited light (L1) and transmitting the long-wavelength light (L2) provided at said one side of the wavelength conversion member (20), including an excited light transmission window (41) transmitting the excited light (L1),
wherein the excited light (L1) emitted from the excited light source (10) is incident upon one side of the wavelength conversion member (20) in a state in which an optical axis of the excited light (L1) is inclined to a surface normal of one side of the wavelength conversion member (20).

3. The light source device of claim 1 or 2, wherein the long-wavelength light (L2) emitted from the wavelength conversion layer (21) is green light.

4. The light source device of claim 1 or 2, wherein the optical axis of the excited light (L1) incident upon one side of the wavelength conversion member (20) is inclined at an angle of 3 ∼ 10° to the surface normal of one side of the wavelength conversion member (20).

5. The light source device of claim 1 or 2, wherein the wavelength conversion layer (21) is formed by a sol-gel process or a deposition process.

## Patentansprüche

1. Lichtquellenvorrichtung, umfassend:
eine angeregte Lichtquelle (10), die angeregtes Licht (L1) emittiert;
ein plattenförmiges Wellenlängenumwandlungselement (20), das eine Lichttransmissionsplatte (22) und eine Wellenumwandlungsschicht (21) aufweist, die auf der Lichttransmissionsplatte (22) ausgebildet ist und das angeregte Licht (L1) von der angeregten Lichtquelle (10) empfängt und langwelliges Licht (L2) emittiert, das eine längere Wellenlänge als das angeregte Licht (L1) aufweist, wobei das angeregte Licht (L1), das von der angeregten Lichtquelle (10) emittiert wird, auf einer Seite des Wellenlängenumwandlungselements (20) auftrifft; und
ein plattenförmiges Filterelement (40), das auf der anderen Seite des Wellenlängenumwandlungselements (20) vorgesehen ist und das angeregte Licht (L1) reflektiert und das langwellige Licht (L2) überträgt;
**gekennzeichnet durch**:
ein plattenförmiges Lichtreflektionselement (30), das an der einen Seite des Wellenlängenumwandlungselements (20) vorgesehen ist, wobei das Lichtreflektionselement (30) das angeregte Licht (L1) und das langwellige Licht (L2) reflektiert und ein angeregtes Lichttransmissionsfenster (31) aufweist, das das angeregte Licht (L1) überträgt,
wobei das angeregte Licht (L1), das von der angeregten Lichtquelle (10) emittiert wird, auf einer Seite des Wellenlängenumwandlungselements (20) in einem Zustand auftrifft, in dem eine optische Achse des angeregten Lichts (L1) zu einer Oberflächennormalen einer Seite des Wellenlängenumwandlungselements (20) geneigt ist.

2. Lichtquellenvorrichtung, umfassend:
eine angeregte Lichtquelle (10), die angeregtes Licht (L1) emittiert;
ein plattenförmiges Wellenlängenumwandlungselement (20), das eine Lichttransmissionsplatte (22) und eine Wellenumwandlungsschicht (21) aufweist, die auf der Lichttransmissionsplatte (22) ausgebildet ist und das angeregte Licht (L1) von der angeregten Lichtquelle (10) empfängt und langwelliges Licht (L2) emittiert, das eine längere Wellenlänge als das angeregte Licht (L1) aufweist, wobei das angeregte Licht (L1), das von der angeregten Lichtquelle (10) emittiert wird, auf einer Seite des Wellenlängenumwandlungselements (20) auftrifft; und
ein plattenförmiges Lichtrefelektionselement (30), das an der anderen Seite des Wellenlängenumwandlungselements (20) vorgesehen ist,
**gekennzeichnet durch**:
ein plattenförmiges Filterelement (40), das das angeregte Licht (L1) reflektiert und das langwellige Licht (L2) überträgt und auf der einen Seite des Wellenumwandlungselements (20) vorgesehen ist, umfassend ein angeregtes Lichttransmissionsfenster (41), das das angeregte Licht (L1) überträgt,
wobei das angeregte Licht (L1), das von der angeregten Lichtquelle (10) emittiert wird, auf einer Seite des Wellenlängenumwandlungselements (20) in einem Zustand auftrifft, in dem eine optische Achse des angeregten Lichts (L1) zu einer Oberflächennormalen einer Seite des Wellenlängenumwandlungselements (20) geneigt ist.

3. Lichtquellenvorrichtung nach Anspruch 1 oder 2, wobei das langwellige Licht (L2), das von der Wellenlängenumwandlungsschicht (21) emittiert wird, grünes Licht ist.

4. Lichtquellenvorrichtung nach Anspruch 1 oder 2, wobei die optische Achse des angeregten Lichts (L1), das auf einer Seite des Wellenlängenumwandlungselements (20) trifft, in einem Winkel von 3 bis 10 Grad zur Oberflächennormalen einer Seite des Wellenlängenumwandlungselements (20) geneigt ist.

5. Lichtquellenvorrichtung nach Anspruch 1 oder 2, wobei die Wellenlängenumwandlungsschicht (21) durch ein Sol-Gel-Verfahren oder ein Abscheidungsverfahren gebildet wird.

## Revendications

1. Dispositif de source de lumière, comprenant :
une source de lumière excitée (10) émettant une lumière excitée (L1) ;
un élément de conversion de longueur d'onde en forme de plaque (20) comportant une plaque de transmission de lumière (22) et une couche de conversion de longueur d'onde (21) formée sur la plaque de transmission de lumière (22) et recevant la lumière excitée (L1) provenant de la source de lumière excitée (10) et émettant une lumière de grande longueur d'onde (L2) ayant une longueur d'onde supérieure à celle de la lumière excitée (L1), la lumière excitée (L1) émise par la source de lumière excitée (10) étant incidente sur un côté de l'élément de conversion de longueur d'onde (20) ; et
un élément de filtre en forme de plaque (40) prévu à l'autre côté de l'élément de conversion de longueur d'onde (20) et réfléchissant la lumière excitée (L1) et transmettant la lumière de grande longueur d'onde (L2),
**caractérisé par** :
un élément de réflexion de lumière en forme de plaque (30) prévu audit côté de l'élément de conversion de longueur d'onde (20), l'élément de réflexion de lumière (30) réfléchissant la lumière excitée (L1) et la lumière de grande longueur d'onde (L2) et comportant une fenêtre de transmission de lumière excitée (31) transmettant la lumière excitée (L1),
où la lumière excitée (L1) émise par la source de lumière excitée (10) est incidente sur un côté de l'élément de conversion de longueur d'onde (20) dans un état où un axe optique de la lumière excitée (L1) est incliné par rapport à une normale à la surface d'un côté de l'élément de conversion de longueur d'onde (20).

2. Dispositif de source de lumière, comprenant :
une source de lumière excitée (10) émettant une lumière excitée (L1) ;
un élément de conversion de longueur d'onde en forme de plaque (20) comportant une plaque de transmission de lumière (22) et une couche de conversion de longueur d'onde (21) formée sur la plaque de transmission de lumière (22) et recevant la lumière excitée (L1) provenant de la source de lumière excitée (10) et émettant une lumière de grande longueur d'onde (L2) ayant une longueur d'onde supérieure à celle de la lumière excitée (L1), la lumière excitée (L1) émise par la source de lumière excitée (10) étant incidente sur un côté de l'élément de conversion de longueur d'onde (20) ; et
un élément de réflexion de lumière en forme de plaque (30) prévu à l'autre côté de l'élément de conversion de longueur d'onde (20),
**caractérisé par** :
un élément de filtre en forme de plaque (40) réfléchissant la lumière excitée (L1) et transmettant la lumière de grande longueur d'onde (L2) prévu audit côté de l'élément de conversion de longueur d'onde (20), comportant une fenêtre de transmission de lumière excitée (41) transmettant la lumière excitée (L1),
dans lequel la lumière excitée (L1) émise par la source de lumière excitée (10) est incidente sur un côté de l'élément de conversion de longueur d'onde (20) dans un état où un axe optique de la lumière excitée (L1) est incliné par rapport à une normale à la surface d'un côté de l'élément de conversion de longueur d'onde (20).

3. Dispositif de source de lumière de la revendication 1 ou 2, dans lequel la lumière de grande longueur d'onde (L2) émise par la couche de conversion de longueur d'onde (21) est une lumière verte.

4. Dispositif de source de lumière de la revendication 1 ou 2, dans lequel l'axe optique de la lumière excitée (L1) incidente sur un côté de l'élément de conversion de longueur d'onde (20) est incliné selon un angle de 3° à 10° par rapport à la normale à la surface d'un côté de l'élément de conversion de longueur d'onde (20) .

5. Dispositif de source de lumière de la revendication 1 ou 2, dans lequel la couche de conversion de longueur d'onde (21) est formée par un procédé sol-gel ou un procédé de dépôt.
